# FASCICULE DE BREVET EUROPEEN

(11) **EP 3 729 118 B1**
(45) Date de publication et mention de la délivrance du brevet: **09.03.2022**
(21) Numéro de dépôt: 18842774.4
(22) Date de dépôt: 18.12.2018
(51) Int. Cl.: G01R 31/36, H02J 7/00

(54) **PROCEDE DE DETERMINATION D'UNE SEQUENCE DE COURANTS DE DECHARGE APPLICABLE A UNE CELLULE LITHIUM-ION A UNE TEMPERATURE DONNEE**
VERFAHREN ZUR BESTIMMUNG EINER FOLGE VON ENTLADUNGSSTRÖMEN, DIE BEI EINER GEGEBENEN TEMPERATUR AUF EINE LITHIUM-IONEN-ZELLE ANWENDBAR SIND
METHOD FOR DETERMINING A SEQUENCE OF DISCHARGE CURRENTS APPLICABLE TO A LITHIUM-ION CELL AT A GIVEN TEMPERATURE

(30) Priorité: 19.12.2017 FR 1762466
(43) Date de publication de la demande: 28.10.2020
(73) Titulaire: Commissariat à l'Energie Atomique et aux Energies Alternatives, 75015 Paris (FR)
(72) Inventeur: KLEIN, Jean-Marie, 73420 Viviers Du Lac (FR); ALLART, David, 73100 Tresserve (FR)
(74) Mandataire: Cabinet Beaumont
(86) Numéro de dépôt international: PCT/FR2018/053390
(87) Numéro de publication internationale: WO 2019/122700

(56) Documents cités:
- EP-A1- 3 190 681
- WO-A1-2015/139922
- DE-A1-102012 214 804
- FR-A1- 2 734 061
- FR-A1- 2 910 735
- FR-A1- 2 964 196
- FR-A1- 3 001 086
- GB-A- 2 350 686
- US-A- 6 061 639

## Description

La présente demande de brevet revendique la priorité de la demande de brevet français FR17/62466.

### Domaine

La présente demande concerne le domaine des batteries électriques de façon générale, et vise plus particulièrement un procédé permettant de déterminer une séquence de courants de décharge applicable à une cellule lithium-ion à une température donnée.

### Exposé de l'art antérieur

Certains systèmes nécessitent des batteries électriques capables de fournir des courants de décharge relativement élevés à des températures relativement basses, typiquement des températures négatives. La technologie lithium-ion est bien adaptée à de telles conditions de fonctionnement. Toutefois, à basse température, pour un type de cellule lithium-ion donné et pour une température de fonctionnement donnée, il existe un courant de décharge maximal à ne pas dépasser sous peine de bloquer la décharge de la cellule, ou d'endommager la cellule.

A une température donnée, et dans le cas d'une application requérant un courant supérieur au courant de décharge maximal applicable à la cellule à la température considérée, une possibilité consiste à, dans un premier temps, faire fonctionner l'application en mode dégradé sous un courant de démarrage inférieur ou égal au courant de décharge maximal applicable à la cellule, puis, lorsque la cellule s'est suffisamment réchauffée sous l'effet de ce courant de démarrage, appliquer le courant de décharge nominal requis par l'application.

Une difficulté réside alors dans la détermination de l'instant de commutation du mode dégradé au mode nominal. Si cette commutation intervient trop tôt, le courant nominal de décharge requis par l'application est appliqué sur une cellule insuffisamment réchauffée, ce qui conduit à bloquer la décharge de la cellule, ou à endommager la cellule. Si la commutation intervient trop tard, l'application fonctionne en mode dégradé pendant une durée inutilement longue, ce qui n'est pas souhaitable.

Il serait souhaitable de pouvoir disposer d'un procédé permettant de déterminer une séquence de courants de décharge applicable à une cellule lithium-ion à une température donnée, cette séquence comportant une première phase de décharge de la cellule sous un courant de démarrage inférieur ou égal au courant maximal applicable à la cellule à la température considérée, suivie d'une deuxième phase de décharge de la cellule sous un courant nominal supérieur au courant maximal applicable à la cellule à la température considérée. En particulier, il serait souhaitable de pouvoir disposer d'un procédé permettant de minimiser la durée de la première phase, tout en prévenant tout risque d'interruption prématurée de la décharge ou de dégradation de la cellule dans la deuxième phase.

Le document WO 2015/139922 A1 divulgue un procédé de détermination, au moyen d'un dispositif électronique de traitement de données, d'une séquence de décharge applicable à une cellule lithium-ion à une température donnée.

### Résumé

Ainsi, un mode de réalisation prévoit un procédé de détermination, au moyen d'un dispositif électronique de traitement de données, d'une première séquence de décharge applicable à une cellule lithium-ion à une température donnée, cette séquence comportant une première phase de décharge de la cellule sous un courant I_{START} inférieur ou égal au courant maximal I_{MAX} applicable à la cellule à ladite température, jusqu'à un niveau de décharge Cd_{TH-OPT}, suivie d'une deuxième phase de décharge de la cellule sous un courant I_{NOM} supérieur au courant I_{MAX}, ce procédé comportant les étapes suivantes :
a) déterminer le seuil U_{TH} correspondant à la tension minimale en dessous de laquelle la cellule ne doit pas descendre sous peine de dégradation;
b) déterminer le courant de décharge maximal I_{MAX}, applicable à la cellule à ladite température, comme le courant le plus élevé pour lequel le minimum local U_{MIN} par lequel passe la tension de la cellule au début de la décharge est supérieur au seuil U_{TH};
c) réaliser au moins une décharge de la cellule, à ladite température, selon une deuxième séquence de décharge comportant une première phase de décharge sous le courant I_{START}, jusqu'à ce que la quantité de charge extraite de la cellule depuis le début de la séquence de décharge atteigne un seuil Cd_{TH} prédéterminé, suivie d'une deuxième phase de décharge sous le courant I_{NOM}, et mesurer une pluralité de points de la courbe de décharge de la cellule pendant la deuxième phase ;
d) déterminer l'ordonnée à l'origine d'une courbe de décharge de la cellule, à ladite température, sous le courant I_{NOM} ;
e) déterminer, par extrapolation à partir des points mesurés à l'étape c) et de l'ordonnée à l'origine déterminée à l'étape d), une fonction h représentative de la courbe de décharge complète de la cellule, à ladite température, sous le courant I_{NOM} ; et
f) déterminer la valeur du niveau de décharge Cd_{TH-OPT} à partir de la fonction h déterminée à l'étape e).

Selon un mode de réalisation, à l'étape e), la fonction h est déterminée par régression polynomiale à partir des points mesurés à l'étape c) et de l'ordonnée à l'origine déterminée à l'étape d).

Selon un mode de réalisation, les points mesurés à l'étape c) comprennent le premier point de passage de la courbe de décharge par un minimum local pendant la deuxième phase de la deuxième séquence.

Selon un mode de réalisation, les points mesurés à l'étape c) comprennent une pluralité de points situés au voisinage du passage de la courbe de décharge par un maximum local pendant la deuxième phase de la deuxième séquence.

Selon un mode de réalisation, à l'étape d), l'ordonnée à l'origine de la courbe de décharge de la cellule sous le courant I_{NOM} est déterminée par extrapolation à partir d'une pluralité de courbes de décharge de référence de la cellule sous des courants de décharge distincts inférieurs au courant I_{MAX}.

Selon un mode de réalisation, l'étape d) comprend les étapes suivantes :
d1) pour chaque courbe de décharge de référence, déterminer la valeur de l'ordonnée à l'origine U₀(I_{REFi}) de la courbe de décharge ;
d2) déterminer, par extrapolation à partir de la pluralité de valeurs d'ordonnée à l'origine déterminées à l'étape b1), une fonction g continue représentative de l'évolution de l'ordonnée à l'origine en fonction de l'intensité du courant de décharge ; et
d3) déterminer l'ordonnée à l'origine de la courbe de décharge complète de la cellule sous le courant I_{NOM} à partir de la fonction g.

Selon un mode de réalisation, chaque courbe de décharge de référence est une succession de valeurs de tension discrètes mesurées aux bornes de la cellule pendant une phase de décharge de la cellule, et l'étape d1) comprend, pour chaque courbe de décharge de référence, les étapes suivantes :
- déterminer, par extrapolation à partir des valeurs de tension discrètes de la courbe de décharge, une fonction continue représentative de l'évolution de la tension aux bornes de la cellule pendant la phase de décharge ; et
- déterminer à partir de cette fonction la valeur de l'ordonnée à l'origine U₀(_{IREFi}) de la courbe de décharge.

Selon un mode de réalisation, pour chaque courbe de décharge de référence, la fonction continue déterminée à l'étape d1) est déterminée par régression polynomiale à partir des valeurs de tension discrètes de la courbe de décharge de référence.

Selon un mode de réalisation, à l'étape f), le dispositif électronique de traitement affecte au niveau de décharge Cd_{TH-OPT} une valeur telle que h(Cd_{TH-OPT}) = U_{TH}, comprise entre un premier niveau de décharge Cd_{MIN} correspondant au passage de la fonction h par un premier minimum local de tension, et un deuxième niveau de décharge Cd_{MAX} supérieur à Cd_{MIN}, correspondant au passage de la fonction h par un premier maximum local de tension, où U_{TH} est un seuil de tension en dessous duquel la tension de la cellule ne doit pas descendre pour ne pas risquer de dégrader la cellule.

Selon un mode de réalisation, le courant I_{START} est sensiblement constant pendant toute la durée de la première phase de décharge de la première séquence.

Selon un mode de réalisation, le courant I_{START} croît de façon monotone pendant toute la durée de la première phase de décharge de la première séquence.

Selon un mode de réalisation, la température est inférieure à 5°C.

Un autre mode de réalisation prévoit un procédé de commande d'une cellule lithium-ion comprenant l'application à la cellule, à une température donnée, d'une séquence de décharge déterminée par un procédé tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont des diagrammes représentant, pour une température de fonctionnement donnée, des courbes de décharge d'une cellule lithium-ion sous plusieurs courants de décharge constants distincts ;
la figure 3 est un schéma bloc d'un exemple d'un mode de réalisation d'un procédé de détermination d'une séquence de décharge applicable à une cellule lithium-ion à une température donnée ; et
les figures 4, 5, 6 et 7 sont des diagrammes illustrant plus en détail des exemples de mise en oeuvre des étapes du procédé de la figure 3.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation pratique d'un dispositif de traitement adapté à mettre en oeuvre le procédé décrit n'a pas été détaillée, la réalisation d'un tel dispositif étant à la portée de l'homme du métier à partir des indications fonctionnelles de la présente description. Sauf précision contraire, les expressions "approximativement", "sensiblement", et "de l'ordre de" signifient à 10 % près, de préférence à 5 % près.

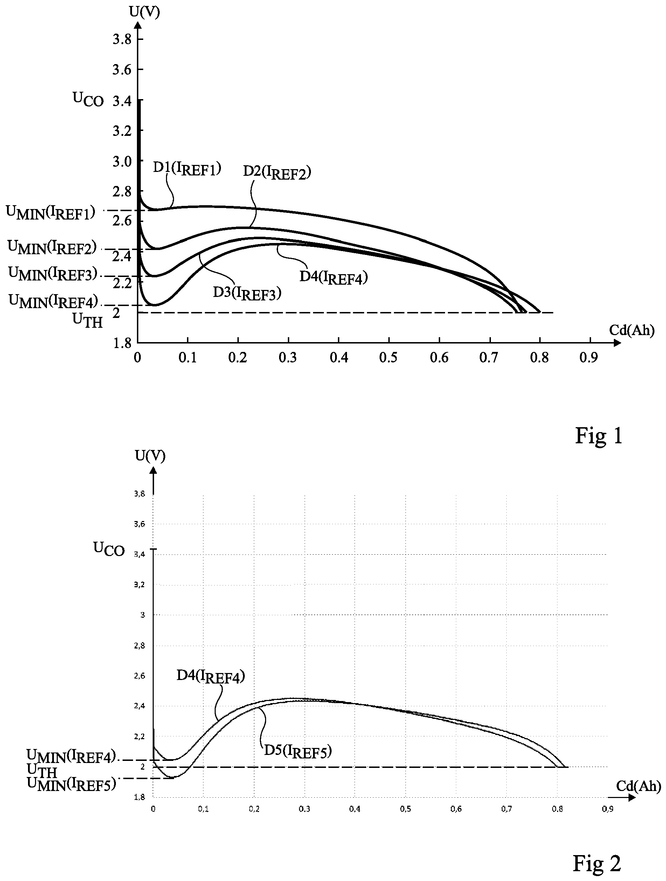

La figure 1 est un diagramme représentant, pour un type de cellule lithium-ion donné et pour une température de fonctionnement donnée, quatre courbes de décharge D1, D2, D3 et D4, sous respectivement quatre courants de décharge constants I_{REF1}, I_{REF2}, I_{REF3} et I_{REF4}, avec I_{REF1} < I_{REF2} < I_{REF3} < I_{REF4}. Chacune des courbes Di, avec i entier allant de 1 à 4 dans cet exemple, représente l'évolution de la tension U aux bornes de la cellule, en volts, en ordonnée, en fonction de la capacité déchargée (c'est-à-dire la quantité de charges extraite de la cellule depuis le début de la phase de décharge) Cd, en ampèreheure, en abscisse, lors d'une décharge complète de la cellule sous le courant I_{REFi}. Dans cet exemple, les courbes D1, D2, D3 et D4 sont tracées pour une température de fonctionnement de -20°C, et pour des courants I_{REF1}, I_{REF2}, I_{REF3} et I_{REF4} respectivement égaux à 1C, 2C, 3C et 4C, où C désigne le courant (en ampères) sous lequel la cellule met une heure à se décharger entièrement depuis son état de pleine charge (soit par exemple 650 mA pour une cellule de capacité égale à 650 mAh).

Dans l'exemple représenté, à l'état pleinement chargé, la tension U_{CO} de la cellule en circuit ouvert est d'environ 3,4 V. Au début de la phase de décharge, la tension aux bornes de la cellule chute rapidement jusqu'à atteindre un premier minimum local U_{MIN}, puis remonte avant de décroître à nouveau de façon monotone jusqu'à la fin de la décharge. Ce phénomène de chute rapide puis de remontée de la tension de la cellule au début de la phase de décharge s'explique par le fait que, à basse température, la résistance interne de la cellule est relativement élevée, entraînant une chute de tension d'autant plus importante que le courant de décharge est élevé. L'échauffement de la cellule sous l'effet du courant de décharge conduit quant à lui à diminuer la résistance interne de la cellule, ce qui tend à faire remonter la tension de la cellule. Comme cela apparaît sur la figure 1, le minimum local U_{MIN} par lequel passe la tension de la cellule au début de la décharge est d'autant plus faible que le courant de décharge est élevé. Dans l'exemple représenté, les valeurs U_{MIN}(I_{REF1}), U_{MIN}(I_{REF2}), U_{MIN}(I_{REF3}) et U_{MIN}(I_{REF4}) sont respectivement de l'ordre de 2,67 V, 2,43 V, 2,25 V et 2,06 V.

La décharge de la cellule est interrompue lorsque la tension de la cellule atteint un seuil de fin de décharge prédéterminé U_{TH}, de l'ordre de 2 V dans l'exemple représenté. Le seuil U_{TH} correspond à la tension minimale en dessous de laquelle la cellule ne doit pas descendre sous peine de dégradation. De façon classique, dans une batterie électrique, chaque cellule est couplée à un système de gestion de la batterie appelé BMS (de l'anglais "Battery Management System"), configuré pour surveiller la tension de la cellule et pour interrompre le courant de décharge de la cellule lorsque la tension de la cellule atteint le seuil U_{TH}.

Pour pouvoir réaliser une décharge complète d'une cellule, il convient que le minimum local U_{MIN} par lequel passe la tension de la cellule au début de la phase de décharge soit supérieur au seuil U_{TH}. En effet, dans le cas contraire, la décharge de la cellule sera interrompue prématurément par le BMS dès le début de la phase de décharge, pour ne pas risquer d'endommager la cellule. Ainsi, l'énergie stockée dans la cellule sera largement sous-utilisée. Ceci est illustré par la figure 2.

La figure 2 est un diagramme similaire à celui de la figure 1, mais sur lequel les courbes de décharge D1, D2 et D3 de la figure 1 n'ont pas été retracées. Sur le diagramme de la figure 2, seule la courbe de décharge D4 de la figure 1 a été tracée, ainsi qu'une courbe de décharge D5, correspondant à une décharge de la cellule, à la température de fonctionnement considérée (-20°C dans cet exemple), sous un courant de décharge constant I_{REF5} supérieur au courant I_{REF4}, par exemple un courant I_{REF5} = 5C.

Comme cela apparaît sur la figure 2, au début de la phase de décharge sous le courant I_{REF5}, la tension aux bornes de la cellule chute rapidement sous le seuil de tension de décharge U_{TH} de la cellule, jusqu'à atteindre un premier minimum local U_{MIN} inférieur à U_{TH}, de l'ordre de 1,91 V dans cet exemple, puis remonte au-dessus du seuil U_{TH} avant de décroître à nouveau de façon monotone jusqu'à la fin de la décharge (c'est-à-dire jusqu'à atteindre à nouveau le seuil U_{TH}).

On notera que la mesure expérimentale de la courbe de décharge D5 de la figure 2 a nécessité de se placer dans des conditions de sécurité particulières, en laboratoire, pour pouvoir laisser la cellule descendre sous son seuil de fin de décharge U_{TH}. En conditions réelles, la décharge de la cellule aurait été interrompue avant le premier franchissement du seuil U_{TH}, pour ne pas risquer d'endommager la cellule. En conséquence, seule une quantité de charge négligeable aurait pu être extraite de la cellule.

Ainsi, pour une température de fonctionnement donnée, le courant de décharge maximal I_{MAX} applicable à une cellule lithium-ion est le courant le plus élevé pour lequel le minimum local U_{MIN} par lequel passe la tension de la cellule au début de la décharge est supérieur au seuil de fin de décharge U_{TH} de la cellule.

Le courant I_{MAX} peut être déterminé de façon empirique. Pour cela, une possibilité est de réaliser des essais successifs de décharge de la cellule, à la température considérée, en augmentant l'intensité du courant de décharge à chaque nouvel essai jusqu'à ce que le minimum local U_{MIN} par lequel passe la tension de la cellule au début de la décharge atteigne le seuil de fin de décharge U_{TH} de la cellule.

A titre de variante, le courant I_{MAX} peut être déterminé par simulation, par extrapolation à partir d'une pluralité de courbes de décharge de référence de la cellule mesurées, à la température considérée, respectivement sous une pluralité de courants de décharge de référence distincts inférieurs au courant I_{MAX}, par exemple les courbes de décharge D1, D2, D3 et D4 de la figure 1. Pour cela, on peut par exemple mettre en oeuvre les étapes successives suivantes :
- pour chaque courbe de décharge de référence, déterminer la valeur de tension U_{MIN} correspondant au premier minium local de la courbe de décharge ;
- déterminer, par extrapolation à partir de la pluralité de valeurs U_{MIN} déterminées à l'étape précédente, par exemple par régression polynomiale, une fonction continue e représentative de l'évolution de la valeur U_{MIN} en fonction de l'intensité du courant de décharge à la température considérée ; et
- déterminer le courant I_{MAX} à partir de la fonction e, par résolution de l'équation e(I_{MAX})=U_{TH}.

Dans certaines applications, on souhaite pouvoir appliquer à une cellule un courant de décharge nominal I_{NOM} relativement élevé. A basse température, il peut arriver que le courant nominal I_{NOM} requis par l'application soit supérieur au courant de décharge maximal I_{MAX} applicable à la cellule à la température considérée. Dans ce cas, le BMS de la batterie peut être configuré pour appliquer à la cellule une séquence de décharge en deux phases, comprenant :
une première phase appelée phase de démarrage, au cours de laquelle un courant de décharge réduit I_{START} est appliqué à la cellule, le courant I_{START} étant inférieur ou égal au courant maximal I_{MAX} applicable à la cellule à la température considérée ; et
une deuxième phase consécutive à la première phase, appelée phase nominale, au cours de laquelle le courant de décharge I_{NOM} est appliqué à la cellule.

Lors de la phase de démarrage, sous l'effet du courant I_{START}, la cellule se réchauffe par effet Joule. Lorsque la température de la cellule est suffisamment élevée pour permettre l'application du courant de décharge nominal I_{NOM}, le BMS commande la commutation du régime de décharge de démarrage au régime de décharge nominal.

A titre d'exemple, le BMS de la batterie est configuré pour, avant le début d'une séquence de décharge d'une cellule :
- mesurer une température représentative de la température de la cellule, par exemple la température ambiante ou la température moyenne de la batterie ;
- déterminer le courant maximal I_{MAX} applicable à la cellule à la température considérée ;
- si le courant nominal I_{NOM} requis par l'application est supérieur au courant I_{MAX}, appliquer à la cellule une séquence de décharge en deux phases du type décrit ci-dessus ; et
- si le courant nominal I_{NOM} requis par l'application est inférieur ou égal au courant I_{MAX}, appliquer directement le courant de décharge I_{NOM} à la cellule.

Le courant I_{START} appliqué pendant la phase de démarrage est de préférence relativement élevé de façon d'une part à ce que le fonctionnement de l'application ne soit pas trop dégradé pendant la phase de démarrage, et d'autre part à ce que le réchauffement de la cellule sous l'effet du courant I_{START} soit relativement rapide. A titre d'exemple, le courant I_{START} est compris dans la plage allant de 0,7*I_{MAX} à I_{MAX}.

En pratique, le BMS peut être configuré pour appliquer à la cellule le courant de démarrage I_{START} jusqu'à ce que la quantité de charge extraite de la cellule (ou capacité déchargée) depuis le début de la séquence de décharge atteigne un seuil Cd_{TH} prédéterminé, fonction de la température mesurée avant le début de la décharge. La commutation de la phase de décharge de démarrage à la phase de décharge nominale intervient lorsque le seuil Cd_{TH} est atteint.

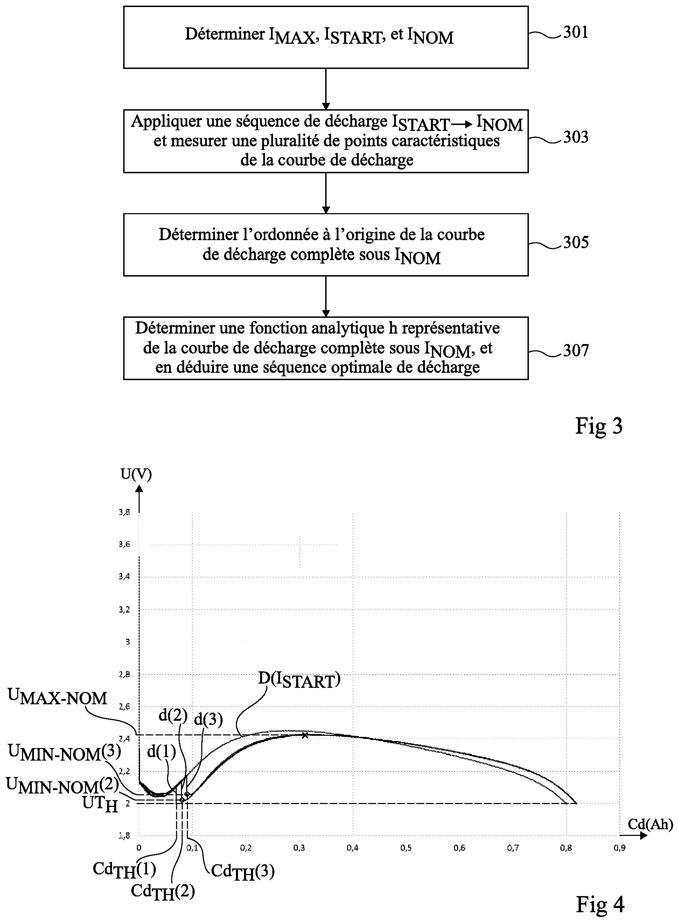

La figure 3 est un schéma bloc d'un exemple d'un mode de réalisation d'un procédé de détermination d'une séquence de décharge applicable à une cellule lithium-ion à une température donnée. Plus particulièrement, le procédé de la figure 3 permet de déterminer, pour une température donnée et pour une séquence de décharge en deux phases du type décrit ci-dessus, une valeur optimale Cd_{TH-OPT} du seuil de décharge Cd_{TH} de la cellule à partir duquel le BMS peut basculer de la phase de décharge de démarrage à la phase de décharge nominale de la cellule, conduisant à minimiser la durée de la phase de décharge de démarrage, tout en prévenant tout risque d'interruption prématurée de la décharge ou de dégradation de la cellule dans la phase nominale.

Une fois la valeur Cd_{TH-OPT} déterminée, elle peut être mémorisée dans un BMS d'une batterie comprenant des cellules du type considéré.

En pratique, le procédé proposé peut être utilisé pour déterminer plusieurs séquences de décharge applicables respectivement pour plusieurs températures de fonctionnement distinctes. Les séquences peuvent être mémorisées dans le BMS de la batterie de façon que le BMS puisse sélectionner et appliquer la séquence de décharge le plus appropriée en fonction de la température mesurée.

On s'intéresse ici plus particulièrement à des températures de fonctionnement suffisamment basses pour que se produise le phénomène décrit ci-dessus de chute rapide puis de remontée de la tension de la cellule au début de la phase de décharge, par exemple des températures inférieures à 5°C, voire inférieures à 0°C.

Le procédé de la figure 3 peut être mis en oeuvre au moyen d'un dispositif électronique de traitement de données, par exemple un ordinateur, ou tout autre dispositif adapté comprenant une mémoire et un microprocesseur.

Dans le procédé de la figure 3, la séquence de décharge applicable à la cellule est déterminée à partir d'une pluralité de courbes de décharge de référence de la cellule à la température considérée, mesurées respectivement sous une pluralité de courants de référence constants inférieurs au courant de décharge maximal I_{MAX} applicable à la cellule à ladite température. A titre d'exemple illustratif, on considère ici que le procédé est mis en oeuvre à partir des courbes de décharge de référence D1, D2, D3 et D4 de la figure 1. Les courbes de décharge de référence peuvent être fournies par le fabricant des cellules. Alternativement, si elles ne sont pas déjà disponibles, les courbes de décharge de référence peuvent être mesurées lors d'essais de caractérisation de la cellule.

Le procédé de la figure 3 comprend une étape initiale 301 de détermination :
- du courant de décharge maximal I_{MAX} applicable à la cellule à la température considérée,
- du courant de démarrage I_{START} appliqué à la cellule pendant la phase de démarrage de la séquence de décharge, et
- du courant nominal I_{NOM} appliqué à la cellule pendant la phase nominale de la séquence de décharge.

Le courant I_{MAX} peut être indiqué par le fabricant de la cellule. S'il n'est pas déjà disponible, le courant I_{MAX} peut être déterminé, comme décrit ci-dessus, par des essais de caractérisation de la cellule, ou par extrapolation à partir des courbes de décharge de référence de la cellule.

Le courant I_{START} est fixé à une valeur inférieure au courant I_{MAX}, par exemple à une valeur comprise dans la plage allant de 0,7*I_{MAX} à I_{MAX}.

Le courant I_{NOM} est quant à lui supérieur au courant I_{MAX}, et correspond au courant de décharge nominal requis par le dispositif à alimenter.

Dans l'exemple illustratif considéré ci-dessus (courbes de la figure 1), le courant I_{MAX} est d'environ 4,37C. Les courbes illustratives décrites ci-après en relation avec les figures 4, 5, 6 et 7 ont été tracées pour un courant de démarrage I_{START} égal à 4C et pour un courant nominal I_{NOM} égal à 5C.

Le procédé de la figure 3 comprend une étape 303 de mise en oeuvre d'au moins une décharge complète de la cellule, à la température considérée, selon une séquence de décharge comportant une première phase de décharge sous le courant I_{START}, jusqu'à un niveau de décharge intermédiaire Cd_{TH}, immédiatement suivie d'une deuxième phase de décharge sous le courant I_{NOM}. A ce stade, le niveau de décharge intermédiaire Cd_{TH} à partir duquel le courant de décharge bascule de la valeur de démarrage I_{START} à la valeur nominale I_{NOM} n'est pas optimisé, c'est-à-dire qu'il est supérieur au niveau de décharge Cd_{TH-OPT} recherché. Autrement dit, la phase de décharge de démarrage est plus longue que nécessaire, c'est-à-dire que la séquence de décharge appliquée permet une décharge complète de la cellule, sans que la tension de la cellule ne vienne buter prématurément sur le seuil de fin de décharge U_{TH} pendant la phase nominale, mais conduit à un fonctionnement en mode dégradé pendant une période inutilement longue.

A titre d'exemple, lors de l'étape 303, on réalise de manière expérimentale une succession d'essais de décharge de la cellule, à la température considérée, en augmentant à chaque nouvel essai, par exemple d'un incrément fixe prédéterminé, le seuil Cd_{TH} de commutation de la phase de démarrage à la phase nominale, jusqu'à parvenir à réaliser au moins une décharge complète de la cellule sans que la tension de la cellule ne vienne buter prématurément sur le seuil de fin de décharge U_{TH} pendant la phase nominale. Ceci est illustré par la figure 4.

La figure 4 est un diagramme similaire à celui des figures 1 et 2, sur lequel ont été tracées :
- une courbe de décharge complète de la cellule sous le courant I_{START} (correspondant, dans l'exemple considéré, à la courbe D4 des figures 1 et 2) ; et
- une pluralité de courbes de décharge d(i) correspondant aux essais successifs de décharge expérimentaux mis en oeuvre à l'étape 303 (avec i entier allant de 1 à n, et n entier supérieur à 1, n = 3 dans l'exemple représenté).

Chaque courbe de décharge d(i) correspond à une tentative de décharge de la cellule selon une séquence en deux phases du type décrit ci-dessus, avec un seuil Cd_{TH}(i) spécifique. Plus particulièrement, dans l'exemple représenté, les trois essais successifs ont été réalisés en fixant respectivement le seuil Cd_{TH} à 0,07 Ah pour le premier essai (courbe d(1)), à 0,08 Ah pour le deuxième essai (courbe d(2)), et à 0,09 Ah pour le troisième essai (courbe d(3)). Comme cela apparaît sur la figure 4, le seuil Cd_{TH}(1)=0,07 Ah est trop faible pour permettre une décharge complète de la cellule. En effet, dès le début de la phase de décharge nominale, la tension de la cellule bute sur le seuil de fin de décharge U_{TH}, ce qui conduit au blocage de la décharge. Les seuils Cd_{TH}(2)=0,08 Ah et Cd_{TH}(3)=0,09 Ah sont en revanche suffisamment élevés pour permettre la décharge complète de la cellule. En effet, on peut voir sur chacune des courbes de décharge d(2) et d(3) que, au début de la phase de décharge nominale, la tension de la cellule chute rapidement jusqu'à un minimum local U_{MIN-NOM} supérieur au seuil U_{TH}, puis remonte avant de décroître à nouveau de façon monotone jusqu'à la fin de la décharge. On peut donc déduire des essais réalisés que, dans l'exemple considéré, le seuil de décharge optimal Cd_{TH_OPT} de commutation entre la phase de décharge de démarrage et la phase de décharge nominale est compris entre la valeur Cd_{TH}(1))=0,07 Ah et la valeur Cd_{TH}(2)=0,08 Ah. On cherche, par le procédé de la figure 3, à déterminer avec une plus grande précision la valeur du seuil de décharge optimal CD_{TH-OPT}, sans avoir à multiplier le nombre d'essais de décharge de la cellule.

On peut observer sur le diagramme de la figure 4 que, à partir d'un niveau de décharge correspondant au premier minimum local U_{MIN-NOM} de la phase de décharge nominale de la courbe d(3), c'est-à-dire au premier minimum local de la courbe d(3) après le seuil Cd_{TH}(3), les courbes d(2) et d(3) sont sensiblement confondues.

Plus généralement, les inventeurs ont déterminé que, pour toute séquence de décharge en deux phases du type décrit ci-dessus, et pour autant que le seuil de commutation entre la phase de décharge de démarrage et la phase de décharge nominale de la cellule soit suffisamment élevé pour permettre une décharge complète de la cellule (sans que la tension de la cellule ne vienne buter prématurément sur le seuil de fin de décharge U_{TH} pendant la phase nominale), la courbe de décharge de la cellule coïncide, à partir d'un niveau de décharge correspondant au passage de la courbe par le premier minimum local U_{MIN-NOM} de la phase de décharge nominale de la séquence, avec une courbe (non représentée sur la figure 4) de décharge complète de la cellule sous le courant I_{NOM} (à savoir la courbe D5 de la figure 2 dans l'exemple considéré).

Lors de l'étape 303, on prévoit de mesurer et stocker dans une mémoire du dispositif de traitement les coordonnées d'une pluralité de points caractéristiques d'au moins une courbe de décharge d(i) de la cellule selon une séquence en deux phases du type décrit ci-dessus, pendant la phase de décharge nominale de la séquence, en vue d'une étape ultérieure 307 de reconstruction, par extrapolation à partir desdits points caractéristiques, de la courbe de décharge complète de la cellule sous le courant I_{NOM}. Plus particulièrement, lors de l'étape 303, on prévoit de mesurer et de mémoriser les coordonnées du premier minimum local U_{MIN-NOM}(i) par lequel passe la tension de la cellule pendant la phase de décharge nominale, c'est-à-dire après le seuil Cd_{TH}(i). On peut en outre mesurer et mémoriser les coordonnées d'un ou plusieurs points de la courbe d(i) situés après le passage de la courbe d(i) par le minimum local U_{MIN-NOM}(i), au voisinage du minimum local U_{MIN-NOM}(i), par exemple des points compris dans la plage de tension allant de U_{MIN-NOM}(i) à U_{MIN-NOM}(i)+U_{MIN-NOM}(i)*X%, où X est une valeur de pourcentage prédéterminée, par exemple comprise entre 1 et 10 %, par exemple de l'ordre de 2 %. De plus, on prévoit ici de mesurer et de mémoriser les coordonnées d'une pluralité de points de la courbe d(i) au voisinage du maximum U_{MAX-NOM}(i) par lequel passe la tension de la cellule pendant la phase de décharge nominale, c'est-à-dire après le seuil Cd_{TH}(i). A titre d'exemple, on prévoit de mesurer et de mémoriser une pluralité de points de la courbe de décharge d(i) de part et d'autre du maximum de tension U_{MAX-NOM}(i), par exemple des points compris dans la plage de tension allant de U_{MAX-NOM}(i) -Y*U_{MAX-NOM}(i) à U_{MAX-NOM}(i), où Y est une valeur de pourcentage prédéterminée, par exemple comprise entre 1 et 10 %, par exemple de l'ordre de 2 %.

En pratique, lors de l'application à la cellule d'une séquence de décharge en deux phases à l'étape 303, on peut prévoir de mesurer et de mémoriser la tension de la cellule à intervalle de temps régulier (c'est-à-dire selon un échantillonnage périodique) tout au long de la décharge. La courbe de décharge d(i) est alors constituée par la succession de valeurs de tension mesurées aux bornes de la cellule pendant la décharge. Les points caractéristiques susmentionnés peuvent alors être extraits de la courbe de décharge d(i) par le dispositif de traitement, postérieurement à l'étape de décharge proprement dite.

Le procédé de la figure 3 comprend de plus une étape 305 de détermination de l'ordonnée à l'origine de la courbe de décharge complète de la cellule sous le courant I_{NOM}, c'est-à-dire de la valeur que prendrait la tension de la cellule à l'instant de début de la phase de décharge, si le courant I_{NOM} était appliqué dès le début de la phase de décharge (à la température considérée).

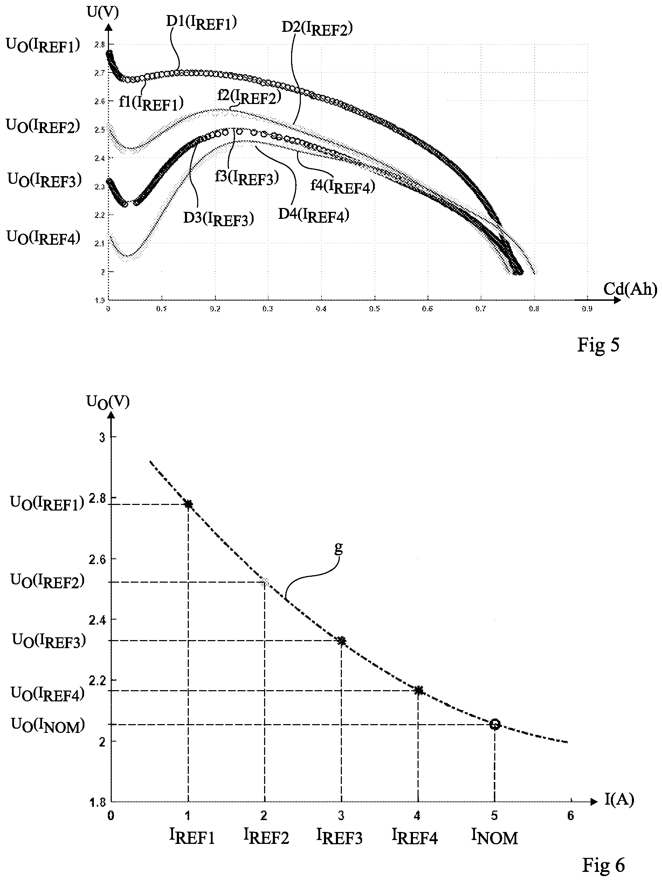

Les figures 5 et 6 illustrent plus en détail un exemple de mise en oeuvre de l'étape 305.

Dans cet exemple, le dispositif de traitement se base sur les courbes de décharge de référence mémorisées au préalable, à savoir les courbes D1, D2, D3 et D4 dans cet exemple, pour déterminer, par extrapolation, la valeur de l'ordonnée à l'origine de la courbe de décharge complète de la cellule sous le courant I_{NOM}.

Dans cet exemple, les courbes de décharge de référence D1, D2, D3 et D4 sont fournies sous la forme de points de mesure de tension discrets. A titre d'exemple, chacune des courbes de décharge de référence Di est constituée d'une succession de valeurs de tension mesurées aux bornes de la cellule à intervalle de temps régulier pendant une phase de décharge de la cellule sous le courant de référence constant I_{REFi}, et stockées dans une mémoire du dispositif de traitement.

L'étape 305 du procédé de la figure 3 comprend alors, pour chacune des courbes de décharge de référence Di, une étape de détermination d'une fonction analytique continue fi approximant la courbe de décharge réelle de la cellule. Chaque fonction fi est par exemple déterminée par un procédé automatique de régression, conduisant à minimiser une grandeur représentative de l'erreur entre la courbe de décharge réelle Di et la fonction fi. Chaque fonction fi est par exemple choisie de façon que le coefficient de corrélation entre la courbe de décharge réelle Di et la fonction fi soit supérieur à un seuil, par exemple supérieur à 0,99. Chaque fonction fi est par exemple déterminée par régression polynomiale à partir de la courbe de décharge réelle Di de la cellule. A titre d'exemple, les fonctions fi sont des polynômes de même ordre k, où k est un entier correspondant au degré le plus faible permettant d'obtenir un coefficient de corrélation supérieur à un seuil prédéterminé, par exemple égal à 0,99, pour toutes les courbes de décharge Di.

La figure 5 est un diagramme similaire à celui de la figure 1, représentant les courbes de décharge de référence réelles D1, D2, D3 et D4, et les courbes de décharge de référence approximées f1, f2, f3 et f4, de la cellule. Dans l'exemple représenté, les fonctions fi sont des polynômes d'ordre 7.

Dans cet exemple, après la détermination des fonctions f1, f2, f3 et f4, l'étape 305 du procédé de la figure 3 comprend une étape de détermination, pour chaque fonction de décharge approximée fi, de la valeur U₀(I_{REFi}) de l'ordonnée à l'origine de la fonction fi, c'est-à-dire la valeur U₀(I_{REFi})= fi(0).

L'étape 305 comprend ensuite la détermination, par extrapolation à partir des valeurs d'ordonnée à l'origine U₀(I_{REFi}) des courbes de décharge de référence, d'une fonction analytique continue g représentative de l'évolution, à la température considérée, de l'ordonnée à l'origine U₀ de la courbe de décharge en fonction de l'intensité I du courant de décharge de la cellule. La fonction g est par exemple déterminée par un procédé automatique de régression, par exemple par régression polynomiale, à partir des valeurs U₀(I_{REFi}). A titre d'exemple, la fonction g est un polynôme d'ordre 2.

La figure 6 est un diagramme représentant la courbe de la fonction g, ainsi que les points U₀(I_{REFi}), U₀(I_{REF2}), U₀(I_{REF3}) et U₀(I_{REF4}) à partir desquels a été extrapolée la fonction g. L'axe des ordonnées représente l'ordonnée à l'origine U₀, en volts, et l'axe des abscisses représente l'intensité I du courant de décharge de la cellule, en ampères.

L'étape 305 du procédé de la figure 3 comprend en outre la détermination, à partir de la fonction g, de l'ordonnée à l'origine U₀(I_{NOM}) de la courbe de décharge complète de la cellule sous le courant I_{NOM}. Pour cela, le dispositif de traitement calcule, à partir de l'expression analytique de la fonction g, la valeur U₀(I_{NOM})=g(I_{NOM}).

Le procédé de la figure 3 comprend de plus une étape 307 de détermination d'une fonction analytique continue h représentative de la courbe de décharge complète de la cellule, à la température considérée, sous le courant I_{NOM}, par extrapolation à partir des points caractéristiques mesurés à l'étape 303, et de la valeur d'ordonnée à l'origine déterminée à l'étape 305.

La fonction h est déterminée par un procédé automatique de régression, conduisant à minimiser une grandeur représentative de l'erreur entre la fonction h d'une part, et les points caractéristiques mesurés à l'étape 303 et la valeur d'ordonnée à l'origine déterminée à l'étape 303 d'autre part. La fonction h est par exemple déterminée par régression polynomiale de même ordre k que les fonctions fi déterminées à l'étape 305.

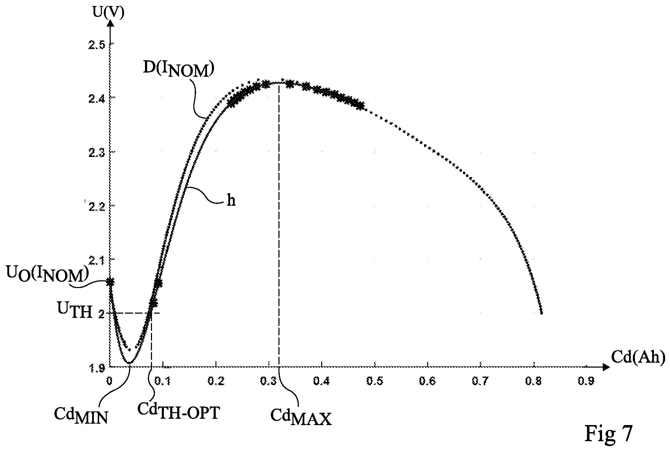

La figure 7 est un diagramme similaire à celui de la figure 1, sur lequel ont été représentés :
- les points caractéristiques mesurés et mémorisés à l'étape 303 (sous la forme d'astérisques non référencés) ;
- l'ordonnée à l'origine déterminée à l'étape 305 ; et
- la fonction h représentative de la courbe de décharge complète sous le courant I_{NOM}, déterminée à l'étape 307.

Sur le diagramme de la figure 7, on a en outre représenté une courbe D(I_{NOM}) de décharge complète réelle de la cellule sous le courant I_{NOM}, mesurée expérimentalement sans tenir compte de la limite basse de tension U_{TH} de la cellule dans le but de valider la méthode proposée (correspondant dans cet exemple à la courbe D5 de la figure 2). Comme cela apparaît sur la figure, la fonction h et la courbe de décharge réelle D(I_{NOM}) sont sensiblement confondues, notamment au niveau du deuxième franchissement du seuil de tension U_{TH} par la cellule (après le passage de la tension de la cellule par un premier minimum local inférieur au seuil U_{TH}).

Lors de l'étape 307, le procédé de la figure 3 comprend en outre la détermination d'une séquence de décharge optimale de la cellule à partir de la fonction h. Plus particulièrement, à partir de la fonction h, le dispositif de traitement détermine le plus petit seuil de décharge Cd_{TH-OPT} à partir duquel le BMS peut basculer de la phase de décharge de démarrage (sous le courant I_{START}) à la phase de décharge nominale (sous le courant I_{NOM}) de la cellule, de façon à minimiser la durée de la phase de décharge de démarrage tout en prévenant tout risque d'interruption prématurée de la décharge ou de dégradation de la cellule pendant la phase nominale. Pour cela, le dispositif de traitement affecte au seuil Cd_{TH-OPT} la valeur de l'abscisse du deuxième point de passage de la fonction h par la tension U_{TH}, correspondant au niveau de décharge de la cellule lors du franchissement du seuil U_{TH} dans la phase de remontée de la tension de la cellule suite au passage de la tension par un premier minimum local inférieur au seuil U_{TH}. Autrement dit, le dispositif de traitement affecte au seuil Cd_{TH-OPT} une valeur telle que h(Cd_{TH-OPT}) = U_{TH}, et comprise entre un premier niveau de décharge Cd_{MIN} correspondant au passage de la fonction h par un premier minimum local de tension, et un deuxième niveau de décharge Cd_{MAX} supérieur à Cd_{MIN}, correspondant au passage de la fonction h par un premier maximum local de tension.

Dans l'exemple considéré, la valeur du seuil Cd_{TH-OPT} déterminée par le procédé de la figure 3 est de 0,075 Ah.

Ainsi, le procédé proposé permet, pour une température donnée, et pour une séquence de décharge en deux phases comprenant une phase de décharge de démarrage, sous un courant de décharge inférieur au courant de décharge maximal applicable à la température considérée, suivie d'une phase de décharge nominale, sous un courant de décharge supérieur au courant de décharge maximal applicable à la température considérée, de déterminer avec précision le seuil de décharge de la cellule à partir duquel la commutation de la phase de décharge de démarrage à la phase de décharge nominale peut être opérée.

Un avantage de ce procédé est qu'il ne nécessite pas la mise en oeuvre d'une décharge réelle complète de la cellule sous un courant supérieur au courant maximal applicable à la température considérée.

Le seuil de décharge Cd_{TH-OPT} déterminé par le procédé proposé peut être stocké dans une mémoire du BMS de la batterie, et être utilisé par le BMS pour appliquer une séquence de décharge appropriée lorsque la batterie est utilisée dans les conditions de température correspondantes.

Des modes de réalisation particuliers ont été décrits. Diverses variantes et modifications apparaîtront à l'homme de l'art. En particulier, on a décrit ci-dessus un exemple de mise en oeuvre du procédé à partir de quatre courbes de décharge réelles de la cellule, mesurées sous quatre courants de décharge constants distincts. Plus généralement, l'homme du métier saura adapter le procédé proposé pour déterminer l'ordonnée à l'origine de la courbe de décharge complète de la cellule sous le courant I_{NOM} à partir d'un nombre p quelconque, supérieur ou égal à 2, de courbes de décharge réelles de la cellule.

En outre, les modes de réalisation décrits ne se limitent pas à l'exemple particulier décrit en relation avec la figure 5 de méthode de détermination des valeurs d'ordonnée à l'origine U₀(I_{REFi}) des courbes de décharge de référence Di. A titre de variante, et en particulier si le pas d'échantillonnage des courbes de décharge réelles Di est suffisamment faible, l'ordonnée à l'origine U₀(I_{REFi}) de chaque courbe Di peut être déterminée directement à partir de la courbe de décharge réelle Di, sans passer par une approximation de la courbe Di par une fonction continue fi.

Par ailleurs, dans les exemples décrits ci-dessus, on a considéré uniquement des exemples dans lesquels le courant I_{START} appliqué à la cellule pendant la phase de démarrage de la séquence de décharge est un courant constant. Les modes de réalisation décrits ne se limitent toutefois pas à ce cas particulier. A titre de variante, le courant I_{START} peut être un courant variable, par exemple un courant croissant de façon monotone tout au long de la phase de décharge de démarrage. Dans ce cas, le seuil de décharge Cd_{TH-OPT} à atteindre avant de pouvoir appliquer le courant nominal I_{NOM} reste le même que celui défini précédemment (0,075 Ah dans l'exemple considéré ci-dessus), mais ce seuil est atteint plus rapidement, ce qui réduit la durée de la phase de fonctionnement en mode dégradé.

## Revendications

1. Procédé de détermination, au moyen d'un dispositif électronique de traitement de données, d'une première séquence de décharge applicable à une cellule lithium-ion à une température donnée, cette séquence comportant une première phase de décharge de la cellule sous un courant I_{START} inférieur ou égal au courant maximal I_{MAX} applicable à la cellule à ladite température, jusqu'à un niveau de décharge Cd_{TH-OPT}, suivie d'une deuxième phase de décharge de la cellule sous un courant I_{NOM} supérieur au courant I_{MAX}, ce procédé comportant les étapes suivantes :
a) déterminer un seuil U_{TH} correspondant à la tension minimale en dessous de laquelle la cellule ne doit pas descendre sous peine de dégradation ;
b) déterminer le courant de décharge maximal I_{MAX} applicable à la cellule à ladite température comme étant le courant le plus élevé pour lequel le minimum local U_{MIN} par lequel passe la tension de la cellule au début de la décharge est supérieur au seuil U_{TH} ;
c) réaliser au moins une décharge de la cellule, à ladite température, selon une deuxième séquence de décharge comportant une première phase de décharge sous le courant I_{START}, jusqu'à ce que la quantité de charge extraite de la cellule depuis le début de la séquence de décharge atteigne un seuil Cd_{TH} prédéterminé, suivie d'une deuxième phase de décharge sous le courant I_{NOM}, et mesurer une pluralité de points de la courbe de décharge (d(i)) de la cellule pendant la deuxième phase ;
d) déterminer l'ordonnée à l'origine (U₀(I_{NOM})) d'une courbe de décharge de la cellule, à ladite température, sous le courant I_{NOM} ;
e) déterminer, par extrapolation à partir des points mesurés à l'étape c) et de l'ordonnée à l'origine déterminée à l'étape d), une fonction h représentative de la courbe de décharge complète de la cellule, à ladite température, sous le courant I_{NOM} ; et
f) déterminer la valeur du niveau de décharge Cd_{TH-OPT} à partir de la fonction h déterminée à l'étape e).

2. Procédé selon la revendication 1, dans lequel, à l'étape e), la fonction h est déterminée par régression polynomiale à partir des points mesurés à l'étape c) et de l'ordonnée à l'origine déterminée à l'étape d).

3. Procédé selon la revendication 1 ou 2, dans lequel les points mesurés à l'étape c) comprennent le premier point de passage de la courbe de décharge (d(i)) par un minimum local pendant la deuxième phase de la deuxième séquence.

4. Procédé selon l'une quelconque des revendications 1 à 3, dans lequel les points mesurés à l'étape c) comprennent une pluralité de points situés au voisinage du passage de la courbe de décharge (d(i)) par un maximum local pendant la deuxième phase de la deuxième séquence.

5. Procédé selon l'une quelconque des revendications 1 à 4, dans lequel, à l'étape d), l'ordonnée à l'origine (U₀(I_{NOM})) de la courbe de décharge de la cellule sous le courant I_{NOM} est déterminée par extrapolation à partir d'une pluralité de courbes de décharge de référence (Di) de la cellule sous des courants de décharge (I_{REFi}) distincts inférieurs au courant I_{MAX}.

6. Procédé selon la revendication 5, dans lequel l'étape d) comprend les étapes suivantes :
d1) pour chaque courbe de décharge de référence (Di), déterminer la valeur de l'ordonnée à l'origine U₀(I_{REFi}) de la courbe de décharge ;
d2) déterminer, par extrapolation à partir de la pluralité de valeurs d'ordonnée à l'origine déterminées à l'étape d1), une fonction g continue représentative de l'évolution de l'ordonnée à l'origine en fonction de l'intensité du courant de décharge ; et
d3) déterminer l'ordonnée à l'origine de la courbe de décharge complète de la cellule sous le courant I_{NOM} à partir de la fonction g.

7. Procédé selon la revendication 6, dans lequel chaque courbe de décharge de référence (Di) est une succession de valeurs de tension discrètes mesurées aux bornes de la cellule pendant une phase de décharge de la cellule, et dans lequel l'étape d1) comprend, pour chaque courbe de décharge de référence (Di), les étapes suivantes :
- déterminer, par extrapolation à partir des valeurs de tension discrètes de la courbe de décharge (Di), une fonction continue (fi) représentative de l'évolution de la tension aux bornes de la cellule pendant la phase de décharge ; et
- déterminer à partir de cette fonction (fi) la valeur de l'ordonnée à l'origine U₀(_{IREFi}) de la courbe de décharge.

8. Procédé selon la revendication 7, dans lequel, pour chaque courbe de décharge de référence (Di), la fonction continue (fi) déterminée à l'étape d1) est déterminée par régression polynomiale à partir des valeurs de tension discrètes de la courbe de décharge de référence (Di).

9. Procédé selon l'une quelconque des revendications 1 à 8, dans lequel, à l'étape f), le dispositif électronique de traitement affecte au niveau de décharge Cd_{TH-OPT} une valeur telle que h(Cd_{TH-OPT}) = U_{TH}, comprise entre un premier niveau de décharge Cd_{MIN} correspondant au passage de la fonction h par un premier minimum local de tension, et un deuxième niveau de décharge Cd_{MAX} supérieur à Cd_{MIN}, correspondant au passage de la fonction h par un premier maximum local de tension.

10. Procédé selon l'une quelconque des revendications 1 à 9, dans lequel le courant I_{START} est sensiblement constant pendant toute la durée de la première phase de décharge de la première séquence.

11. Procédé selon l'une quelconque des revendications 1 à 9, dans lequel le courant I_{START} croît de façon monotone pendant toute la durée de la première phase de décharge de la première séquence.

12. Procédé selon l'une quelconque des revendications 1 à 11, dans lequel ladite température est inférieure à 5°C.

13. Procédé de commande d'une cellule lithium-ion comprenant l'application à la cellule, à une température donnée, d'une séquence de décharge déterminée par un procédé selon l'une quelconque des revendications 1 à 12.

## Patentansprüche

1. Ein Verfahren zum Bestimmen, mittels einer elektronischen Datenverarbeitungsvorrichtung, einer ersten Entladungssequenz, die auf eine Lithium-Ionen-Zelle bei einer gegebenen Temperatur anwendbar ist, wobei diese Sequenz eine erste Phase der Entladung der Zelle unter einem Strom I_{START}, der kleiner oder gleich dem maximalen Strom I_{MAX} ist, der auf die Zelle bei dieser Temperatur anwendbar ist, bis zu einem Entladungsniveau Cd_{TH-OPT} aufweist, gefolgt von einer zweiten Phase der Entladung der Zelle unter einem Strom I_{NOM}, der größer als der Strom I_{MAX} ist, wobei dieses Verfahren die folgenden Schritte aufweist:
a) Bestimmen eines Schwellenwerts U_{TH}, der der Mindestspannung entspricht, unter die die Zelle nicht fallen darf, um Schäden zu vermeiden;
b) Bestimmen des maximalen Entladestroms I_{MAX}, der für die Zelle bei der genannten Temperatur anwendbar ist, als der höchste Strom, für den der lokale Minimalwert U_{MIN}, den die Zellenspannung zu Beginn der Entladung durchläuft, größer ist als der Schwellenwert U_{TH};
c) Durchführen mindestens einer Entladung der Zelle bei der genannten Temperatur gemäß einer zweiten Entladungssequenz, die eine erste Entladungsphase unter Strom I_{START} aufweist, bis die seit dem Beginn der Entladungssequenz aus der Zelle entnommene Ladungsmenge einen vorbestimmten Schwellenwert Cd_{TH} erreicht, gefolgt von einer zweiten Entladungsphase unter Strom I_{NOM}, und Messen einer Vielzahl von Punkten der Kurve (d(i)) der Zellentladung während der zweiten Phase;
d) Bestimmen der Ordinate am Ursprung (U₀(I_{NOM})) einer Kurve der Zellentladung bei der genannten Temperatur unter Strom I_{NOM};
e) Bestimmen einer Funktion h, die für die Kurve der vollständigen Entladung der Zelle bei der genannten Temperatur unter Strom I_{NOM} repräsentativ ist, durch Extrapolation aus den in Schritt c) gemessenen Punkten und aus der in Schritt d) bestimmten Ordinate am Ursprung; und
f) Bestimmen des Wertes des Entladungsniveaus Cd_{TH-OPT} auf der Grundlage der im Schritt e) bestimmten Funktion h.

2. Verfahren nach Anspruch 1, wobei in Schritt e) die Funktion h durch polynomiale Regression aus den in Schritt c) gemessenen Punkten und aus der in Schritt d) bestimmten Ordinate am Ursprung bestimmt wird.

3. Verfahren nach Anspruch 1 oder 2, wobei die in Schritt c) gemessenen Punkte den ersten Punkt aufweisen, an dem die Entladungskurve (d(i)) während der zweiten Phase der zweiten Sequenz einen lokalen Minimalwert durchläuft.

4. Verfahren nach einem der Ansprüche 1 bis 3, wobei die in Schritt c) gemessenen Punkte eine Vielzahl von Punkten aufweisen, die in der Nähe des Übergangs der Entladungskurve (d(i)) durch einen lokalen Maximalwert während der zweiten Phase der zweiten Sequenz liegen.

5. Verfahren nach einem der Ansprüche 1 bis 4, wobei in Schritt d) die Ordinate am Ursprung (U₀(I_{NOM})) der Kurve der Zellentladung unter dem Strom I_{NOM} durch Extrapolation auf der Grundlage einer Vielzahl von Referenzkurven (Di) der Zellentladung unter verschiedenen Entladeströmen (I_{REFi}), die kleiner als der Strom I_{MAX} sind, bestimmt wird.

6. Verfahren nach Anspruch 5, wobei Schritt d) die folgenden Schritte aufweist:
d1) für jede Referenzentladungskurve (Di), Bestimmen des Wertes der Ordinate am Ursprung (U₀(I_{REFi})) der Entladungskurve
d2) Bestimmen einer kontinuierlichen Funktion g, die für die Veränderung der Ordinate am Ursprung in Abhängigkeit von der Intensität des Entladungsstroms repräsentativ ist, durch Extrapolation aus der Vielzahl der in Schritt d1) bestimmten Werte der Ordinate am Ursprung; und
d3) Bestimmen der Ordinate am Ursprung der Kurve der vollständigen Entladung der Zelle unter Strom I_{NOM} auf der Grundlage der Funktion g.

7. Verfahren nach Anspruch 6, wobei jede Referenzentladungskurve (Di) eine Folge von diskreten Spannungswerten ist, die über der Zelle während einer Zellentladungsphase gemessen werden, und wobei Schritt d1) für jede Referenzentladungskurve (Di) die folgenden Schritte aufweist:
- Bestimmen, durch Extrapolation aus den diskreten Spannungswerten der Entladungskurve (Di), einer kontinuierlichen Funktion (fi), die für die Variation der Spannung über der Zelle während der Entladungsphase repräsentativ ist; und
- Bestimmen des Wertes der Ordinate am Ursprung (U₀(I_{REFi})) der Entladungskurve auf der Grundlage dieser Funktion (fi).

8. Verfahren nach Anspruch 7, wobei für jede Referenzentladungskurve (Di) die in Schritt d1) bestimmte kontinuierliche Funktion (fi) durch polynomiale Regression aus den diskreten Spannungswerten der Referenzentladungskurve (Di) bestimmt wird.

9. Verfahren nach einem der Ansprüche 1 bis 8, wobei die elektronische Verarbeitungseinrichtung in Schritt f) dem Entladungspegel einen Wert Cd_{TH-OPT} derart zuordnet, dass h(Cd_{TH-OPT}) = U_{TH}, zwischen einem ersten Entladungspegel Cd_{MIN}, der dem Durchlaufen der Funktion h durch einen ersten lokalen minimalen Spannungswert entspricht, und einem zweiten Entladungspegel Cd_{MAX}, der größer als Cd_{MIN} ist und dem Durchlaufen der Funktion h durch einen ersten lokalen maximalen Spannungswert entspricht.

10. Verfahren nach einem der Ansprüche 1 bis 9, wobei der Strom I_{START} während der gesamten ersten Entladephase der ersten Sequenz im Wesentlichen konstant ist.

11. Verfahren nach einem der Ansprüche 1 bis 9, wobei der Strom I_{START} während der gesamten ersten Entladephase der ersten Sequenz monoton ansteigt.

12. Verfahren nach einem der Ansprüche 1 bis 11, wobei die Temperatur weniger als 5°C beträgt.

13. Verfahren zur Steuerung einer Lithium-Ionen-Zelle, wobei die Zelle bei einer bestimmten Temperatur mit einer Entladesequenz beaufschlagt wird, die durch ein Verfahren nach einem der Ansprüche 1 bis 12 bestimmt wird.

## Claims

1. Method of determining, by means of an electronic data processing device, a first discharge sequence applicable to a lithium-ion cell at a given temperature, this sequence comprising a first phase of cell discharge under a current I_{START} smaller than or equal to the maximum current I_{MAX} applicable to the cell at said temperature, down to a discharge level Cd_{TH-OPT}, followed by a second phase of cell discharge under a current I_{NOM} greater than current I_{MAX}, this method comprising the steps of:
a) determining a threshold U_{TH} corresponding to the minimum voltage below which the cell should not fall to avoid damage;
b) determining the maximum discharge current I_{MAX} applicable to the cell at said temperature as being the highest current for which the local minimum value U_{MIN} through which the cell voltage transits at the beginning of the discharge is greater than threshold U_{TH};
c) performing at least one discharge of the cell, at said temperature, according to a second discharge sequence comprising a first phase of discharge under current I_{START}, until the quantity of charge extracted from the cell since the beginning of the discharge sequence reaches a predetermined threshold Cd_{TH}, followed by a second phase of discharge under current I_{NOM}, and measuring a plurality of points of the curve (d(i)) of cell discharge during the second phase;
d) determining the ordinate at the origin (U₀(I_{NOM})) of a curve of cell discharge, at said temperature, under current I_{NOM};
e) determining, by extrapolation from the points measured at step c) and from the ordinate at the origin determined at step d), a function h representative of the curve of full discharge of the cell, at said temperature, under current I_{NOM}; and
f) determining the value of the discharge level Cd_{TH-OPT} based on the function h determined at step e).

2. Method according to claim 1, wherein, at step e), function h is determined by polynomial regression from the points measured at step c) and from the ordinate at the origin determined at step d).

3. Method according to claim 1 or 2, wherein the points measured at step c) comprise the first point at which the discharge curve (d(i)) transits through a local minimum value during the second phase of the second sequence.

4. Method according to any of claims 1 to 3, wherein the points measured at step c) comprise a plurality of points located in the vicinity of the transition of discharge curve (d(i)) through a local maximum value during the second phase of the second sequence.

5. Method according to any of claims 1 to 4, wherein, at step d), the ordinate at the origin (U₀(I_{NOM})) of the curve of cell discharge under current I_{NOM} is determined by extrapolation based on a plurality of reference curves (Di) of cell discharge under different discharge currents (I_{REFi}) smaller than current I_{MAX}.

6. Method according to claim 5, wherein step d) comprises the steps of:
d1) for each reference discharge curve (Di), determining the value of the ordinate at the origin (U₀(I_{REFi})) of the discharge curve;
d2) determining, by extrapolation from the plurality of values of ordinate at the origin determined at step d1), a continuous function g representative of the variation of the ordinate at the origin according to the intensity of the discharge current; and
d3) determining the ordinate at the origin of the curve of full discharge of the cell under current I_{NOM} based on function g.

7. Method according to claim 6, wherein each reference discharge curve (Di) is a succession of discrete voltage values measured across the cell during a cell discharge phase, and wherein step d1) comprises, for each reference discharge curve (Di), the steps of:
- determining, by extrapolation from the discrete voltage values of the discharge curve (Di), a continuous function (fi) representative of the variation of the voltage across the cell during the discharge phase; and
- determining based on this function (fi) the value of the ordinate at the origin (U₀(I_{REFi})) of the discharge curve.

8. Method according to claim 7, wherein, for each reference discharge curve (Di), the continuous function (fi) determined at step d1) is determined by polynomial regression from the discrete voltage values of the reference discharge curve (Di).

9. Method according to any of claims 1 to 8, wherein, at step f), the electronic processing device assigns to the discharge level a value Cd_{TH-OPT} such that h(Cd_{TH-OPT}) = U_{TH}, between a first discharge level Cd_{MIN} corresponding to the transiting of function h through a first local minimum voltage value, and a second discharge level Cd_{MAX} greater than Cd_{MIN}, corresponding to the transiting of function h through a first local maximum voltage value.

10. Method according to any of claims 1 to 9, wherein current I_{START} is substantially constant all along the first discharge phase of the first sequence.

11. Method according to any of claims 1 to 9, wherein current I_{START} increases monotonously all along the first discharge phase of the first sequence.

12. Method according to any of claims 1 to 11, wherein said temperature is lower than 5°C.

13. Method of controlling a lithium-ion cell, comprising the application to the cell, at a given temperature, of a discharge sequence determined by a method according to any of claims 1 to 12.
